(19) Europäisches Patentamt
European Patent Office
Office européen des brevets

(11) EP 0 780 697 A1

(12) # DEMANDE DE BREVET EUROPEEN

(43) Date de publication:
**25.06.1997 Bulletin 1997/26**

(51) Int Cl.6: **G01R 33/24**

(21) Numéro de dépôt: **96402759.3**

(22) Date de dépôt: **17.12.1996**

(84) Etats contractants désignés:
**DE FR GB IT**

(30) Priorité: **19.12.1995 FR 9515050**

(71) Demandeur: **COMMISSARIAT A L'ENERGIE ATOMIQUE**
**75015 Paris Cédex 15 (FR)**

(72) Inventeurs:
- **Moussavi, Mehdi**
  **38700 Corenc (FR)**
- **Lang, Karine**
  **38000 Grenoble (FR)**

(74) Mandataire: **Dubois-Chabert, Guy et al**
**c/o BREVATOME**
**25, rue de Ponthieu**
**75008 Paris (FR)**

(54) **Solution radicalaire pour magnétomètre à résonance magnétique nucléaire**

(57) L'invention concerne une solution radicalaire pour magnétométrie à résonance magnétique nucléaire, résistante aux gradients de champs magnétiques sur une large gamme de températures. Cette solution est constituée par un radical nitroxyde de formule :

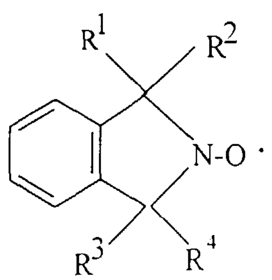

(I)

dans laquelle $R^1$, $R^2$, $R^3$ et $R^4$ qui peuvent être identiques ou différents, représentent un groupe alkyle ou un groupe alkoxy éventuellement deutérés, ou dans laquelle les couples $R^1$-$R^2$ et/ou $R^3$-$R^4$ forment ensemble un groupe cycloalkyle ou polycycloalkyle éventuellement deutéré, et N représente $^{14}N$ ou $^{15}N$,
dissous dans un solvant constitué par un éther diméthylique de formule :

$$CH_3O(CH_2CH_2O)n\ CH_3 \qquad (II)$$

dans laquelle n est égal à 3 ou 4.

EP 0 780 697 A1

## Description

La présente invention a pour objet une solution radicalaire pour magnétomètre à résonance magnétique nucléaire à polarisation dynamique.

De façon plus précise, elle concerne une nouvelle solution radicalaire dont le signal de résonance magnétique nucléaire (RMN) en champ faible est exploitable sur une large gamme de température, stable à haute température et peu sensible aux gradients de champ magnétique.

Elle s'applique en particulier à la magnétométrie RMN à polarisation dynamique dans des conditions extrêmes de température et d'environnement magnétique caractéristiques des puits de forage.

Les performances des magnétomètres RMN à polarisation dynamique sont fortement liées à la solution radicalaire entrant dans la constitution du magnétomètre, et donc au comportement de cette solution dans la gamme de températures et de gradients de champ magnétique appliquée au magnétomètre.

Dans la thèse de R. Besson de l'Université Joseph Fourier de Grenoble, 1973, pages 47 à 49 et 65 à 67, il est fait mention de plusieurs solutions radicalaires utilisables en magnétométrie. Depuis le premier radical utilisé (sel de Frémy), la technique a évolué vers d'autres radicaux nitroxydes du type N-O• un peu plus stables et permettant une amplification du signal RMN du solvant par polarisation dynamique plus élevée. Des radicaux nitroxydes de ce type sont en particulier décrits dans les documents FR-A-2 653 121 et EP-A-O 185 825.

La solution radicalaire actuellement utilisée dans les magnétomètres pour puits de forage est la solution, dénommée ci-après solution Thétis, qui est constituée du radical nitroxyde Tanane (2,2,6,6-tétraméthyl pipéridine-1-oxyle) à une concentration de $10^{-3}$ mol/l dans un solvant constitué par un mélange d'eau et de diglyme à 5 % (éther diméthylique du diéthylène glycol).

Cette solution radicalaire permet un fonctionnement du magnétomètre dans la gamme de températures allant de 10°C à 125°C pour un gradient de champ magnétique très faible. Avec cette solution, le signal RMN se détériore fortement en présence de gradients plus élevés et la plage de fonctionnement du magnétomètre est de ce fait limitée à un gradient de quelques centaines de nT. De plus, la valeur limite acceptable diminue lorsque la température augmente, ainsi cette limite est de 700 nT à 40°C et elle diminue a 500, puis 200 nT aux températures respectives de 70, puis 100°C.

La plage de fonctionnement du magnétomètre n'est donc pas suffisante pour qu'il puisse être employé avec succès dans des puits de grande profondeur caractérisés par une température ambiante pouvant être supérieure à 125°C et par la présence de boues magnétiques qui génèrent des gradients de champ pouvant dépasser 1000 nT/m.

En outre, les solutions radicalaires soumises à des températures élevées ne sont pas stables en raison d'un processus de disparition du radical -NO• lié à la formation d'hydroxylamine par réaction avec les protons du solvant hydrogéné à température élevée, selon le processus réactionnel suivant :

$$-NO^{\bullet} + H \rightarrow -NOH$$

qui conduit à la transformation du radical nitroxyde en hydroxylamine.

Il serait donc intéressant de disposer de solutions radicalaires convenant pour un fonctionnement du magnétomètre à des températures dépassant 125°C avec des gradients de champ pouvant dépasser 1000 nT/m.

On sait que la performance d'une solution radicalaire est liée au facteur de polarisation dynamique FPD qui peut être défini par l'équation suivante :

$$FPD = \frac{2.f.A}{g.\omega_1} \Phi(\Delta H_{RPE})$$

dans laquelle :

- A est la constante d'interaction hyperfine du radical,
- g est le nombre de niveaux d'énergie du radical,
- $\omega_I$ est la pulsation de Larmor du proton,
- f est le facteur d'efficacité du couplage entre les protons ou solvant et l'électron libre du radical,
- $\phi$ est une fonction décroissante de la largeur de raie RPE à haut champ de la solution, $\Delta H_{RPE}$, et du nombre de raies du spectre de résonance paramagnétique électronique.

Dans le cas de la solution Thétis (solution de Tanane à une concentration de $10^{-3}$ mol/l dans le mélange eau + 5 % diglyme) $\Delta H_{RPE}$ est de 32 μT à 20°C.

Le comportement de la solution radicalaire dépend également :

- du temps de relaxation RMN, $T_2$, et
- de la stabilité du couple radical-solvant pour les applications à hautes températures.

Dans le cas du temps de relaxation $T_2$, plus ce temps est court et plus l'effet produit par un gradient de champ magnétique sur la solution est négligeable. Ainsi, pour la solution Thétis, $T_2$ est de 1,1 s à 20°C et $T_2$ croît approximativement exponentiellement avec la température pour atteindre 5,37 s à 120°C.

Aussi, pour avoir une solution radicalaire donnant un bon signal RMN, il convient tout d'abord de rechercher un couple radical-solvant stable, de couplage efficace, c'est-à-dire de facteur d'efficacité (f) le plus proche de 1, de largeur de raie RPE fine et de temps de relaxation $T_2$ inférieur à 1,1 s à 20°C, pour que la solution radicalaire soit plus résistante aux gradients de champs magnétiques que la solution Thétis utilisée actuellement.

La présente invention a précisément pour objet une solution radicalaire présentant ces propriétés en vue d'être utilisée pour la magnétométrie à résonance magnétique nucléaire à polarisation dynamique, dans la gamme de températures allant de 0°C à 150°C avec des gradients de champs magnétiques pouvant dépasser 1000 nT/m.

Selon l'invention, la solution radicalaire contient un radical nitroxyde et elle est caractérisée en ce qu'elle est constituée par un radical nitroxyde de formule :

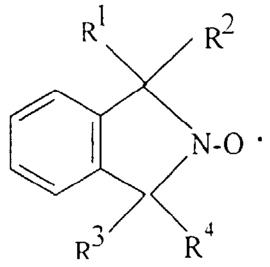

(I)

dans laquelle $R^1$, $R^2$, $R^3$ et $R^4$ qui peuvent être identiques ou différents, représentent un groupe alkyle ou un groupe alkoxy éventuellement deutérés, ou dans laquelle les couples $R^1$-$R^2$ et/ou $R^3$-$R^4$ forment ensemble un groupe cycloalkyle ou polycycloalkyle éventuellement deutéré, et N représente $^{14}N$ ou $^{15}N$,
dissous dans un solvant constitué par un éther diméthylique de formule :

$$CH_3O(CH_2CH_2O)n\ CH_3 \qquad (II)$$

dans laquelle n est égal à 3 ou 4.

Dans la formule I donnée ci-dessus pour le radical nitroxyde, les groupes $R^1$, $R^2$, $R^3$ et $R^4$ peuvent être des groupes alkyle ou alkoxy, ou former ensemble des groupes cycloalkyle. Les groupes alkyle ou alkoxy utilisables peuvent être des groupes linéaires ou ramifiés, ayant généralement de 1 à 5 atomes de carbone, dont tout ou partie des atomes d'hydrogène peuvent être remplacés par des atomes de deutérium D.

Lorsque $R^1$-$R^2$ et/ou $R^3$-$R^4$ forment ensemble un groupe cycloalkyle, celui-ci a de préférence 4 à 11 atomes de carbone. De préférence $R^1$, $R^2$, $R^3$ et $R^4$ sont des groupes alkyle inférieurs de 1 à 4 atomes de carbone, en particulier des groupes méthyle.

Dans ce radical nitroxyde, l'atome d'azote peut être $^{14}N$ ou $^{15}N$. On préfère utiliser $^{15}N$. De même, on préfère utiliser des groupes alkyle ou alkoxy deutérés pour $R^1$, $R^2$, $R^3$ et $R^4$.

A titre d'exemple de radical nitroxyde approprié, on peut citer ceux qui répondent aux formules :

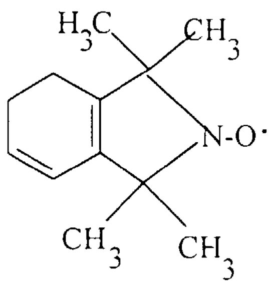

(III) et

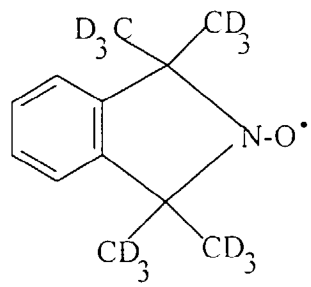

(IV)

Conformément à l'invention, l'utilisation d'un radical nitroxyde répondant aux formules (III et IV) données ci-dessus, permet d'obtenir une stabilité améliorée de la solution par rapport à ce que l'on obtient avec le radical du type Tanane.

En effet, le fait d'ajouter au radical nitroxyde du type 2,2,5,5,-tétraméthylpyrrolidine-1-oxyle un cycle à 6 atomes de carbone, constitué par un cycle benzénique, permet d'augmenter le volume de la molécule, de la rigidifier pour en faire une molécule plane et d'augmenter sa stabilité. Ainsi, en solution dans l'eau à une concentration de $10^{-3}$ mol/l, le radical nitroxyde de formule :

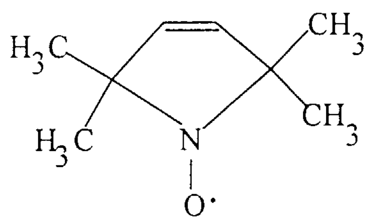

(5)

présente une durée de demi-vie de 250 heures à 150°C dans l'eau alors que le radical nitroxyde de formule (III) utilisé dans l'invention présente à cette même température une durée de demi-vie largement supérieure à 250 heures puisque la perte de signal dans le même solvant n'est que de 10% au bout de 300 heures.

On précise que la durée de 1/2 vie d'un radical nitroxyde correspond au temps écoulé entre le moment où l'on porte le radical à la température voulue et le moment où le signal RPE de ce radical a perdu 50% de sa valeur initiale.

Le radical nitroxyde répondant à la formule (III) donnée ci-dessus est décrit en particulier par R. Bolton et al dans J. Chem. Soc. Perkin Trans. 2, 1993, pages 2049-2052.

Dans la solution radicalaire de l'invention, le solvant utilisé qui est constitué par un éther diméthylique répondant à la formule (II) présente un degré de pureté élevé qui peut être obtenu par bidistillation. En effet, il est important de supprimer certaines des impuretés susceptibles de se trouver dans le solvant, qui pourraient entraîner la dégradation du radical. En particulier, l'étape de bidistillation permet de supprimer le 2,6 di-tert-butyl-4-méthylphénol qui est utilisé comme stabilisant dans les produits commerciaux de formule (II) afin d'éviter la formation de peroxydes. La suppression de ce stabilisant (antioxydant) permet d'éviter la dégradation du radical par formation d'hydroxylamine.

Dans la solution radicalaire de l'invention, on choisit l'éther diméthylique de formule (II) de façon à obtenir le facteur d'efficacité (f) le plus proche de 1 sans pour autant provoquer un élargissement trop important des raies RPE. De préférence, on utilise un éther diméthylique de formule (II) dans laquelle n est égal à 3 ou 4, les meilleurs résultats étant obtenus lorsque n est égal à 3.

La concentration en radical nitroxyde de la solution est choisie de façon à obtenir un bon signal RMN tout en obtenant un bon facteur de polarisation dynamique FPD.

Généralement, on obtient de bons résultats avec des concentrations se situant dans la gamme de $10^{-3}$ à $10^{-2}$ mol/l.

Les radicaux nitroxyde de formule (I) utilisés dans l'invention peuvent être préparés par des procédés classiques. On peut utiliser en particulier le mode de synthèse décrit dans Aust. J. Chem. 1983, 36, p 397-401.

L'invention a également pour objet une sonde de magnétomètre à résonance magnétique nucléaire, comprenant deux ensembles composés chacun d'une bobine entourant un récipient rempli d'un échantillon constitué par une solution contenant un radical nitroxyde, et deux cavités résonantes pour exciter les deux échantillons à deux fréquences distinctes, caractérisée en ce que chaque échantillon est une solution d'un radical nitroxyde conforme à l'invention.

D'autres caractéristiques et avantages de l'invention apparaîtront mieux à la lecture de la description qui suit, donnée bien entendu à titre illustratif et non limitatif, en référence aux dessins annexés.

La figure 1 est un diagramme représentant l'évolution du facteur d'efficacité (f) en fonction de la température (en°C) d'une solution radicalaire conforme à l'invention (référence 1) et d'une solution radicalaire conforme à l'art antérieur (référence T).

La figure 2 est un diagramme illustrant l'évolution de la largeur de raie (en µTesla) en fonction de la température (en °C) pour des solutions radicalaires (1) et (2) conformes à l'invention et pour la solution T conforme à l'art antérieur.

La figure 3 est un diagramme représentant l'évolution du temps de relaxation RMN, $T_2$ (en s), en fonction de la température (en °C) pour les solutions radicalaires 1 et 2 conformes à l'invention, la solution radicalaire T conforme à l'art antérieur et la solution C donnée à titre comparatif.

La figure 4 est un diagramme représentant le facteur amplificateur (rapport r : $T_2$ solution T/$T_2$ solution 1 ou 2) en fonction de la température (en °C).

La figure 5 est un diagramme représentant le signal RMN (en Volt) en fonction de l'intensité (en mA) pour la solution 1 conforme à l'invention à des températures de 20, 40, 60 et 80°C et pour la solution T conforme à l'art antérieur à ces mêmes températures.

La figure 6 est un diagramme représentant le signal RMN (en Volt) en sortie de sonde, en fonction de la température (en °C) pour des intensités de 0 mA, 3,5 mA, 7 mA, 10,5 mA et 14 mA dans le cas de la solution radicalaire 1 de l'invention et de la solution radicalaire T de l'art antérieur.

La figure 7 est un diagramme représentant la durée de demi-vie de la solution radicalaire 1 de l'invention en fonction de la température (en °C).

Les figures 8 à 10 sont des diagrammes représentant le signal nucléaire (en µV) de capteurs à résonance magnétique nucléaire à polarisation dynamique utilisant, soit la solution 1 de l'invention, soit la solution T de l'art antérieur, en fonction du gradient de champ magnétique extérieur appliquée dans l'axe du capteur (en nT/m), à une température de 20°C (figure 8), de 50°C (figure 9) et de 100°C (figure 10).

Les figures 11 à 14 sont des diagrammes représentant l'évolution du rapport signal à bruit (en dB/ $\sqrt{Hz}$ ) en sortie d'oscillateurs nucléaires utilisant la solution 1 de l'invention à 40°C (figure 11) et 70°C (figure 12) ou la solution T à 40°C (figure 13) et 70°C (figure 14), en fonction du gradient de champ magnétique extérieur appliqué (en nT/m).

La figure 15 est un diagramme représentant les variations du signal nucléaire RMN (en V) en sortie de sonde en fonction de la température (en °C) pour la solution 1 de l'invention et pour la solution C donnée à titre comparatif.

La figure 16 est une représentation schématique d'une sonde à résonance magnétique nucléaire conforme à l'invention.

Dans la description qui suit, on utilise deux solutions radicalaires conformes à l'invention comprenant le radical nitroxyde (Tmio 15D) de formule (I) dans laquelle $R^1$, $R^2$, $R^3$ et $R^4$ sont le groupe méthyle deutéré et N représente $^{15}N$, dans du triglyme c'est-à-dire l'éther diméthylique de formule (II) avec n égal à 3. Le triglyme utilisé est le produit commercial auquel on a fait subir une bidistillation pour supprimer les impuretés, notamment le stabilisant présent dans le produit commercial.

La solution radicalaire 1 comprend $2.10^{-3}$ mol/l de Tmio 15D et la solution 2 comprend $10^{-3}$ mol/l de Tmio 15D.

A titre comparatif, on utilise également la solution T de l'art antérieur, constituée par le radical nitroxyde Tanane à une concentration de $10^{-3}$ mol/l dans le mélange eau-5 % diglyme (solution Thétis) et la solution C constituée par du Tmio 15D à un concentration de $10^{-3}$ mol/l dans le mélange eau -5 % diglyme.

Une autre solution 3 conforme à l'invention comprend du Tmio 15D à une concentration de $10^{-3}$ mol/l dans du tétraglyme, soit l'éther diméthylique de formule (II) avec n égal à 4.

Dans le tableau 1 ci-dessous on a regroupé les propriétés à 20°C et à 120°C des solutions 1, 2 et 3 conformes à l'invention ainsi que celle de la solution de l'art antérieur (solution Thétis).

TABLEAU 1

| | | $\Delta H_{RPE}$ | F | $T_2$ (s) |
|---|---|---|---|---|
| **Solution 1** | | | | |
| $2.10^{-3}$M | 20°C | 34 µT | 0,77 | 0,48 |
| | 120°C | 69 µT | 0,7 | 2,5 |
| **Solution 2** | | | | |
| $10^{-3}$M | 20°C | 27 µT | 0,45 | 0,34 |
| | 120°C | 47,9 µT | 0,53 | 3,27 |
| **Solution 3** | | | | |
| $10^{-3}$M | 20°C | 30 µT | 0,40 | 0,39 |
| | 120°C | 40 µT | 0,57 | 2,71 |

TABLEAU 1 (suite)

| | | $\Delta H_{RPE}$ | F | $T_2$ (s) |
|---|---|---|---|---|
| **Solution T** | | | | |
| $10^{-3}$M | 20°C | 32 µT | 0,66 | 1,1 |
| | 120°C | 71,9 µT | 0,54 | 5,37 |

Au vu de ce tableau, on remarque que les largeurs de raies sont plus fines avec les solutions de l'invention, et que le facteur d'efficacité est plus élevé et le temps de relaxation est plus court avec la solution 1.

On obtient donc de meilleures propriétés avec les solutions radicalaires de l'invention. Par ailleurs, on note qu'en doublant la concentration en radical nitroxyde (solution 1), on accroît très fortement le signal RMN à travers le facteur d'efficacité (0,77) sans pour autant provoquer un élargissement trop important des raies RPE. En revanche, dans le cas de la solution T de l'art antérieur, si l'on double la concentration en Tanane, l'élargissement de la raie RPE est trop important.

La tenue aux gradients de champ étant liée au temps de relaxation $T_2$ très court, les solutions de l'invention résistent à des gradients de champ deux à trois fois supérieurs aux gradients supportés par la solution de l'art antérieur car leurs temps de relaxation sont nettement plus courts.

Les propriétés des solutions 1 et 2 conformes à l'invention sont décrites plus en détail en référence aux figures 1 à 15. Sur ces figures, on a donné à titre comparatif les résultats obtenus avec la solution T (solution Thétis) conforme à l'art antérieur.

La figure 1 représente l'évolution du facteur d'efficacité (f) des solutions 1 et 2 conformes à l'invention et de la solution T conforme à l'art antérieur en fonction de la température (en °C).

Ce facteur d'efficacité (f) a été déterminé en mesurant les temps de relaxation $T_1$ et $T_{10}$ des solutions radicalaires et du solvant pur respectivement puisque $f = 1 - \frac{T_1}{T_{10}}$ . Sur cette figure 1, on remarque que le gain en facteur d'efficacité est de 55 à 70 % suivant la température dans le cas de la solution 1. En revanche, le gain de la solution 2 n'intervient que pour des températures très élevées.

Sur la figure 2, on a représenté l'évolution de la largeur de raie RPE (en µTesla)des solutions 1 et 2 conformes à l'invention, et de la solution T de l'art antérieur en fonction de la température (en °C). Les largeurs de raies ont été déterminées selon la méthode décrite dans le Journal de Physique, Tome 36, Juin 1975, pages 571 à 580.

Sur la figure 2, on remarque que les largeurs de raies RPE de la solution 1 sont comparables à celles de la solution T. En revanche les largeurs de raies de la solution 2 sont plus faibles.

Sur la figure 3, on a représenté l'évolution du temps de relaxation $T_2$ (en s) en fonction de la température (en °C) pour les solutions 1 et 2 conformes à l'invention, la solution T de l'art antérieur et la solution C donnée à titre comparatif, comprenant $10^{-3}$ mol/l de Tmio dans un solvant identique à celui de la solution T (eau + 5% de diglyme). Ces temps de relaxation ont été déterminés par la méthode de précession libre comme décrite dans la thèse de M.P. Ferroud Plattet de l'Université Joseph Fourier de Grenoble, 1992, pages 125-141. Au vu de cette figure, on remarque que l'on obtient des temps de relaxation plus courts avec les solutions de l'invention et qu'elles ont de ce fait une meilleure résistance aux gradients de champs.

On remarque par ailleurs que si l'on change le solvant de la solution 2 de l'invention en le remplaçant par de l'eau avec 5 % du diglyme (solution C), on obtient des temps de relaxation $T_2$ extrêmement plus longs. Ainsi, la solution C n'est pas du tout appropriée pour les applications du forage. En effet, pour que la solution soit efficace en présence de gradients de champs magnétiques importants (conditions du forage liées à la présence de boues magnétiques) le temps de relaxation nucléaire $T_2$ doit être le plus court possible. Si l'on compare sur la figure 3 la variation des temps de relaxation nucléaires $T_2$ de chaque solution (solutions 1 et 2 de l'invention et solution C de Tmio avec le solvant eau + 5% diglyme), on voit que l'écart varie de plus d'un facteur 2 à 3 pour les températures entre 100°C et 150°C dans le cas des solutions 2 et C et que pour la solution 1 de l'invention qui est deux fois plus concentrée, l'écart est encore plus favorable.

La figure 4 qui représente le rapport r du temps de relaxation $T_2$ de la solution T sur le temps de relaxation $T_2$ de la solution 1 ou de la solution 2 en fonction de la température (en °C), confirme ces résultats.

Ceci traduit le facteur amplificateur du gradient de champ applicable à la solution de l'invention en fonction de la concentration en radical nitroxyde. Le gradient applicable est deux à trois fois supérieur aux gradients auparavant acceptables pour la solution T.

Sur la figure 5, on a représenté le signal RMN (en Volt) en sortie d'une sonde de laboratoire pour la solution 1 conforme à l'invention et la solution T de l'art antérieur à des températures de 20, 40, 60 et 80°C, en fonction de l'intensité (en mA) qui traduit le gradient de champ. Ainsi, pour 3,5 mA le gradient de champ est de 350 nT/m dans la direction transversale et de 40 nT/m dans la direction longitudinale. Les courbes ont été obtenues à l'aide d'un spectromètre RMN bas champ conçu au laboratoire.

Pour un gradient de champ nul et une température supérieure à 20°C, le signal RMN de la solution T de l'art antérieur est supérieur à celui de la solution 1 de l'invention.

En revanche, pour une température inférieure ou égale à 20°C, et quelle que soit la valeur du gradient de champ magnétique, la solution 1 de l'invention est meilleure.

A 40°C, pour un gradient de champ supérieur à 15 nT/m dans la direction longitudinale de la sonde (respectivement 126 nT/m dans la direction transversale), le signal RMN de la solution 1 devient supérieur à celui de la solution T de l'art antérieur et ce phénomène s'amplifie avec la température. A température croissante, le gradient minimal pour que la solution 1 soit meilleure, diminue fortement ; il est divisé par trois à 80°C.

Ainsi, en présence d'un gradient de champ faible, le signal RMN de la solution 1 de l'invention est toujours supérieur à celui de la solution T sur toute la gamme de température étudiée, et cet avantage s'accroît avec la valeur du gradient appliqué car le signal RMN de la solution T chute brutalement alors que celui de la solution 1 de l'invention diminue progressivement.

La figure 6 illustre le signal RMN en sortie de sonde (en Volt) en fonction de la température (en °C) pour divers gradients de champs ; cette figure illustre la plage de température sur laquelle peut fonctionner un magnétomètre utilisant la solution de l'invention.

La plage de fonctionnement du capteur s'évalue à partir de la plage de température pour laquelle le signal RMN enregistré sur le spectromètre de laboratoire (sonde haute température) est supérieur à la limite L de 0,6 Volt. Sur cette figure on retrouve l'affaissement très rapide du signal RMN de la solution T dû au gradient de champ, qui est à comparer au signal de la solution 1 qui décroît plus lentement. La plage de fonctionnement du capteur contenant la solution 1 est donc -30 à +130°C dans un milieu à fort gradient de champ magnétique alors que le capteur utilisant la solution T ne fonctionne plus ; cette plage est de 0°C à +150 C° dans un milieu magnétiquement propre, pour la solution 1.

Connaissant les gradients limites supportés par le capteur utilisant la solution T, soit 700 nT/m, 500 nT/m et 200 nT/m environ aux températures respectives de 40, 70 et 100°C, on peut prévoir que les valeurs des gradients équivalents pour la solution 1 sont approximativement de 1900 nT/m, 1200 nT/m et 450 nT/m respectivement aux mêmes températures.

Sur la figure 7, on a représenté la cinétique de dégradation de la solution 1 de l'invention à 150°C. Cette figure illustre le pourcentage de signal RPE obtenu après chauffage en fonction de la durée de chauffe à 150°C (en heure).

Sur cette figure, la courbe 4 illustre le pourcentage de signal RPE après chauffe, et la courbe 5 illustre le pourcentage de signal RPE après chauffe et repos.

Sur cette figure, on remarque que la durée de demi-vie ( 50 % du signal RPE) est de 180 heures.

Sur les figures 8 à 10, on a représenté l'évolution du signal nucléaire (en µV) en sortie de capteurs à résonance magnétique nuléaire à polarisation dynamique utilisant la solution 1 de l'invention ou la solution T de l'art antérieur, en fonction du gradient de champ magnétique (en nT/m) appliqué dans l'axe du capteur à 20°C (figure 8), 50°C (figure 9) et 100°C (figure 11).

Sur chaque figure, les courbes sont référencées 1 pour la solution 1 de l'invention et T pour la solution T de l'art antérieur, avec de plus l'indication de la tension d'injection (en mV).

L'examen de ces courbes montre qu'en l'absence de gradient et aux températures supérieures à 100°C, le signal nucléaire en sortie du capteur avec la solution de l'invention est supérieur à celui des capteurs utilisant la solution T de l'art antérieur fonctionnant avec une tension d'injection de 10 mV. Le gain est de 88 %, 73 % et 100 % dans un gradient de champ magnétique de 200 nT/m aux températures respectives de 20°C, 50°C et 100°C.

De plus, le même niveau de signal est atteint pour la solution 1 de l'invention pour un gradient trois fois plus fort à 20°C, entre quatre et cinq fois plus fort à 50°C et sept fois plus grand à 100°C que la solution T (Tanane + eau + 5 % diglyme, M/1000).

Sur les figures 11 à 14, on a représenté l'évolution du rapport signal à bruit S/B (en dB/ $\sqrt{Hz}$ ) en fonction du gradient de champ magnétique extérieur (en nT/m) appliqué dans l'axe du capteur, pour des oscillateurs nucléaire comprenant le capteur réalisé avec la solution 1 de l'invention ou la solution T de l'art antérieur et une électronique associée qui rend l'ensemble fonctionnel en milieu industriel.

Les conditions d'excitation des résonances nucléaire et magnétique étaient les suivantes :

tension d'injection $V_{inj}$ = 40 mV
puissance HF $P_{hf}$ = 0,6 W

dans le cas des figures 11 et 12 se rapportant à la solution 1 de l'invention, à une température de 40°C (figure 11) et 70°C (figure 12).

Dans le cas des figures 13 (température de 40°C) et 14 (température de 70°C) concernant la solution T, les conditions d'excitation étaient :

$$V_{inj} = 40 \text{ mV et } P_{hf} = 0{,}6 \text{ W}.$$

L'examen des courbes des figures 11 à 14 montre que l'oscillateur utilisant la solution 1 de l'invention a un meilleur comportement en fonction de la température et de la présence de gradients de champs magnétiques que le magnétomètre réalisé avec la solution de l'art antérieur.

Alors que le capteur avec la solution T ne fonctionne qu'en présence de gradients inférieurs à 500 nT/M à 40°C et 400 nT/M à 70°C, le capteur utilisant la solution de l'invention fonctionne sur la même gamme de température en présence de gradients atteignant des valeurs de 1500 nT/m.

Sur la figure 15, on a représenté la variation du signal RMN (en V) en fonction de la température (en °C) pour la solution 1 de l'invention et pour la solution C donnée à titre comparatif.

Sur cette figure, on voit que le signal RMN de la solution C est nettement plus faible que celui de la solution 1 de l'invention alors que la largeur de la raie RPE de cette solution (0,57 G à 150°C) est relativement faible et est déjà très favorable à la polarisation dynamique. Si on utilisait une solution Tmio M/500 dans l'eau+5% diglyme, le signal RMN ne serait pas meilleur. En effet la relaxation électronique augmentant avec la concentration radicalaire, la solution aurait des largeurs de raies RPE supérieures et un facteur de polarisation dynamique et donc un signal RMN encore moindre. D'autre part, le temps de relaxation nucléaire $T_2$ resterait toujours supérieur à celui de la solution de l'invention.

Ainsi, l'utilisation conformément à l'invention d'un solvant constitué par du triglyme ou du tétraglyme permet l'application des solutions de Tmio en magnétométrie dans les forages pétroliers.

Sur la figure 16, on a représenté une coupe schématique d'une sonde d'un magnétomètre à résonance magnétique nucléaire, dans laquelle on peut utiliser la solution de l'invention. La sonde est constituée de deux ensembles similaires 3 et 5 alignés selon l'axe ZZ' ; l'ensemble 3 se compose d'une bobine 7 formant un circuit basse fréquence créant le champ d'excitation de la résonance protonique et servant également à la détection du signal nucléaire, qui entoure un premier échantillon 8. L'ensemble 5 se compose d'une bobine 7' formant un circuit haute fréquence créant le champ d'excitation de la résonance électronique constitué par un résonateur coaxial accordé à la fréquence donnant le maximum d'amplification dynamique. La bobine 7' entoure l'échantillon 8'. Les échantillons 8 et 8' sont constitués par la solution radicalaire de l'invention et ils sont contenus dans deux récipients indépendants 10 et 10' constitués par des flacons sphériques symétriques dont les parois sont revêtues d'une peinture argentée selon des secteurs séparés les uns des autres par des interruptions. La cavité résonante d'excitation comprend deux cylindres argentés 12 et 12' reliés au conducteur initial d'un câble coaxial 13.

Dans cette sonde, le signal nucléaire apparaît à la fréquence de Larmor :

$$Fo = \frac{\gamma_I B_o}{2\pi}$$

$\gamma_I$ étant le rapport gyromagnétique du proton et $B_o$ le champ magnétique terrestre.

L'électronique adaptée en sortie de sonde mesure la fréquence du signal et fournit donc la valeur du champ terrestre.

Cette sonde est actuellement utilisée sur des puits de forage de la compagnie Schlumberger. Il existe d'autres géométries utilisant les mêmes principes.

Cette sonde est très intéressante car elle permet d'effectuer des mesures de champs magnétiques à des températures aussi élevées que 180°C, sans destruction de la sonde.

## Revendications

1. Solution contenant un radical nitroxyde pour magnétométrie par résonance magnétique nucléaire, caractérisée en ce qu'elle est constituée par un radical nitroxyde de formule :

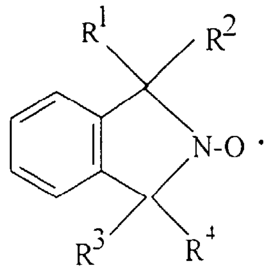

(I)

dans laquelle $R^1$, $R^2$, $R^3$ et $R^4$ qui peuvent être identiques ou différents, représentent un groupe alkyle ou un groupe alkoxy éventuellement deutérés, ou dans laquelle les couples $R^1$-$R^2$ et/ou $R^3$-$R^4$ forment ensemble un groupe cycloalkyle ou polycycloalkyle éventuellement deutéré, et N représente $^{14}N$ ou $^{15}N$,
dissous dans un solvant constitué par un éther diméthylique de formule :

$$CH_3O(CH_2CH_2O)n\ CH_3 \qquad (II)$$

dans laquelle n est égal à 3 ou 4.

2. Solution selon la revendication 1, caractérisée en ce que $R^1$, $R^2$, $R^3$ et $R^4$ représentent le groupe méthyle éventuellement deutéré.

3. Solution selon l'une quelconque des revendications 1 et 2 caractérisée en ce que N représente $^{15}N$.

4. Solution selon l'une quelconque des revendications 1 à 3, caractérisée en ce que le solvant est un éther diméthylique de formule (II) avec n égal à 3.

5. Solution selon l'une quelconque des revendications 3 et 4, caractérisée en ce que le solvant est un éther diméthylique de formule (II) avec n égal à 4

6. Solution selon l'une quelconque des revendications 1 à 5, caractérisée en ce qu'elle comprend $10^{-3}$ à $10^{-2}$ mol/l de radical nitroxyde.

7. Solution selon la revendication 1, caractérisée en ce qu'elle est constituée par le 1,1,3,3-tétraméthylisoindoline-2-yloxyl dissous à une concentration de $2.10^{-3}$ mol/l dans l'éther diméthylique de formule (II) avec n égal à 3.

8. Sonde de magnétomètre à résonance magnétique nucléaire comprenant deux ensembles composés chacun d'une bobine entourant un récipient rempli d'un échantillon constitué par une solution contenant un radical nitroxyde, et deux cavités résonantes pour exciter les deux échantillons à deux fréquences distinctes, caractérisée en ce que chaque échantillon est une solution d'un radical nitroxyde selon l'une quelconque des revendications 1 à 7.

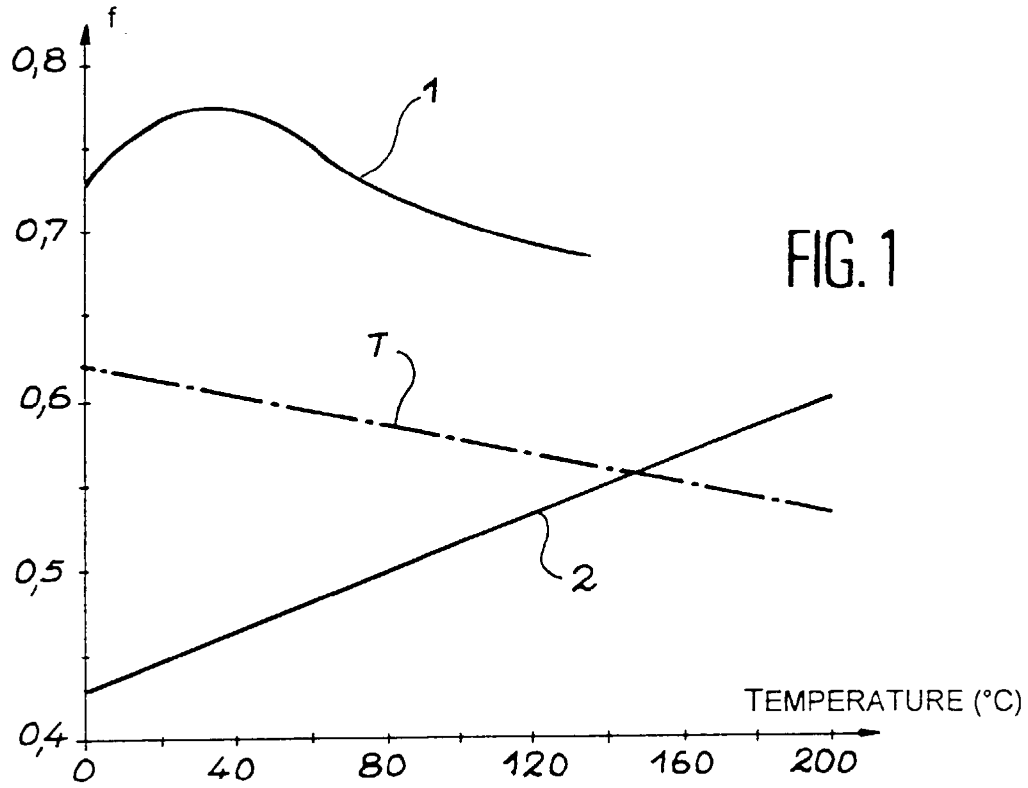
f
0,8
0,7
0,6
0,5
0,4
1
T
2
TEMPERATURE (°C)
0
40
80
120
160
200

FIG. 1

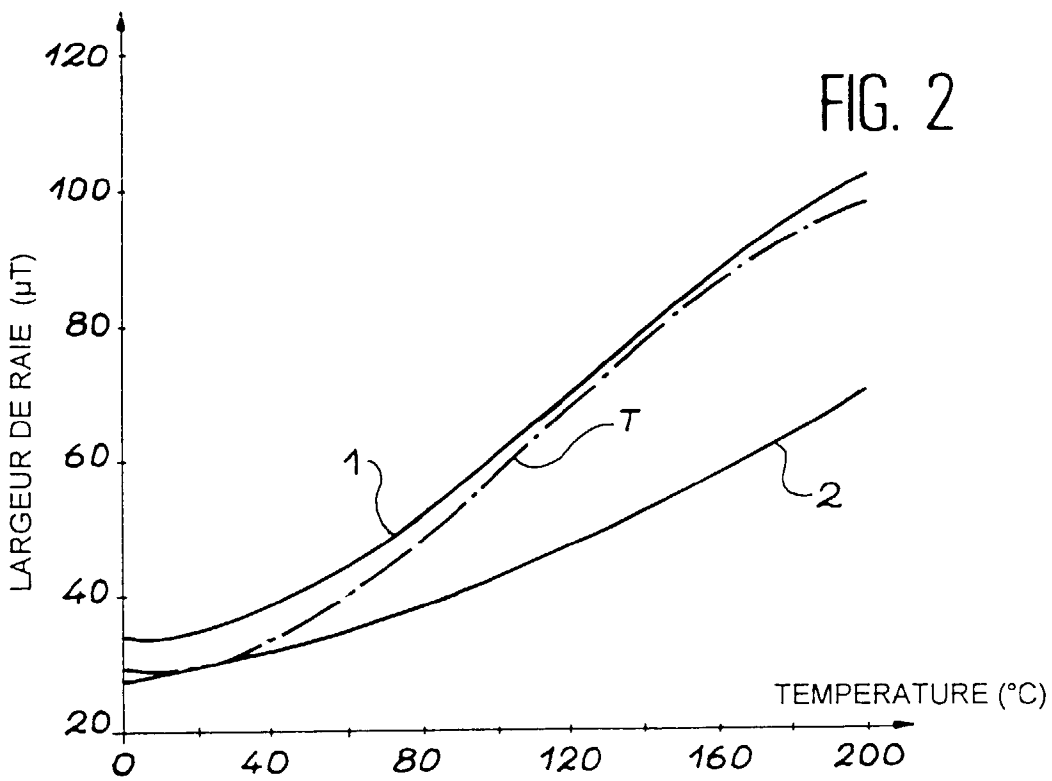
120
100
80
60
40
20
LARGEUR DE RAIE (µT)
1
T
2
TEMPERATURE (°C)
0
40
80
120
160
200

FIG. 2

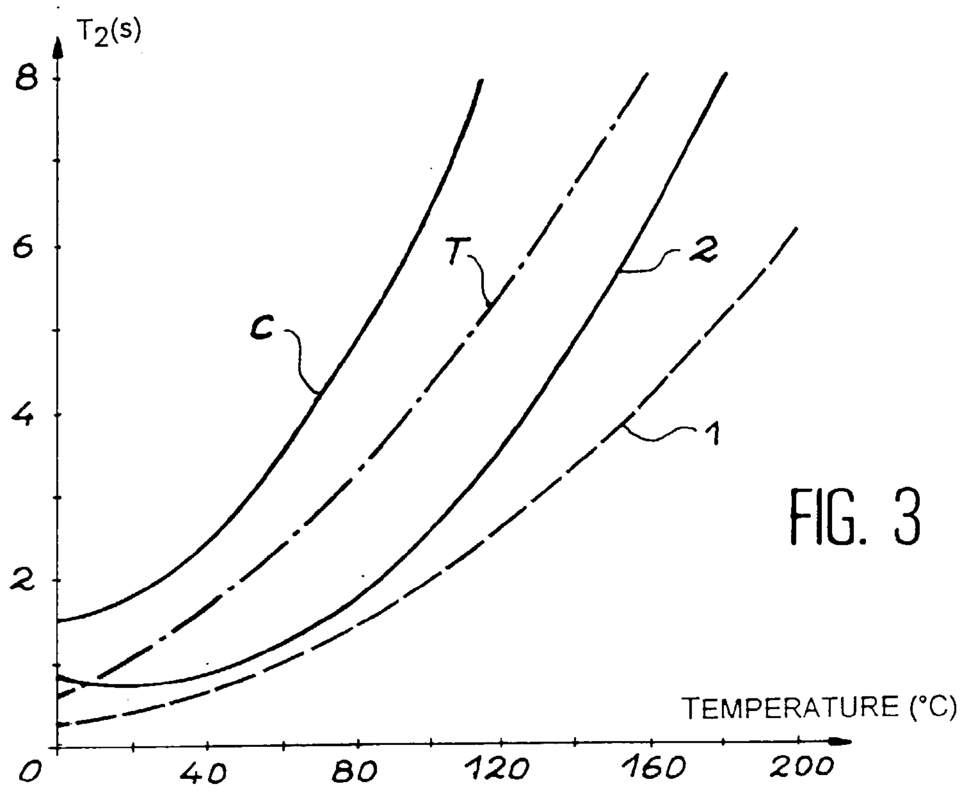
T2(s)
8
6
4
2
0
40
80
120
160
200
TEMPERATURE (°C)
C
T
2
1

FIG. 3

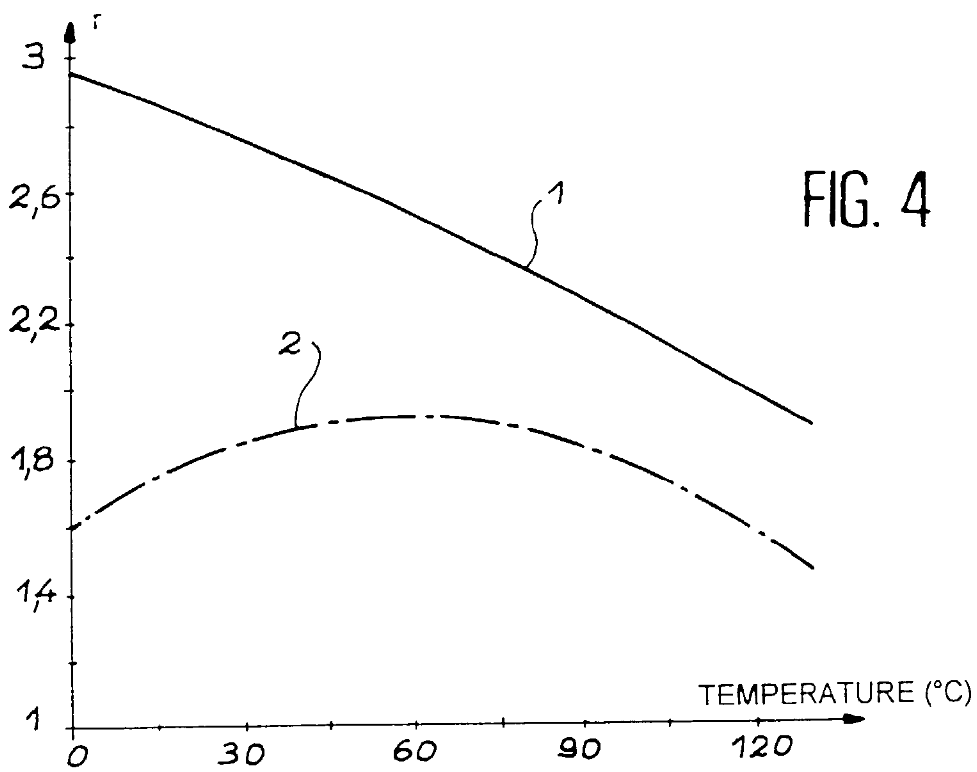
r
3
2,6
2,2
1,8
1,4
1
0
30
60
90
120
TEMPERATURE (°C)
1
2

FIG. 4

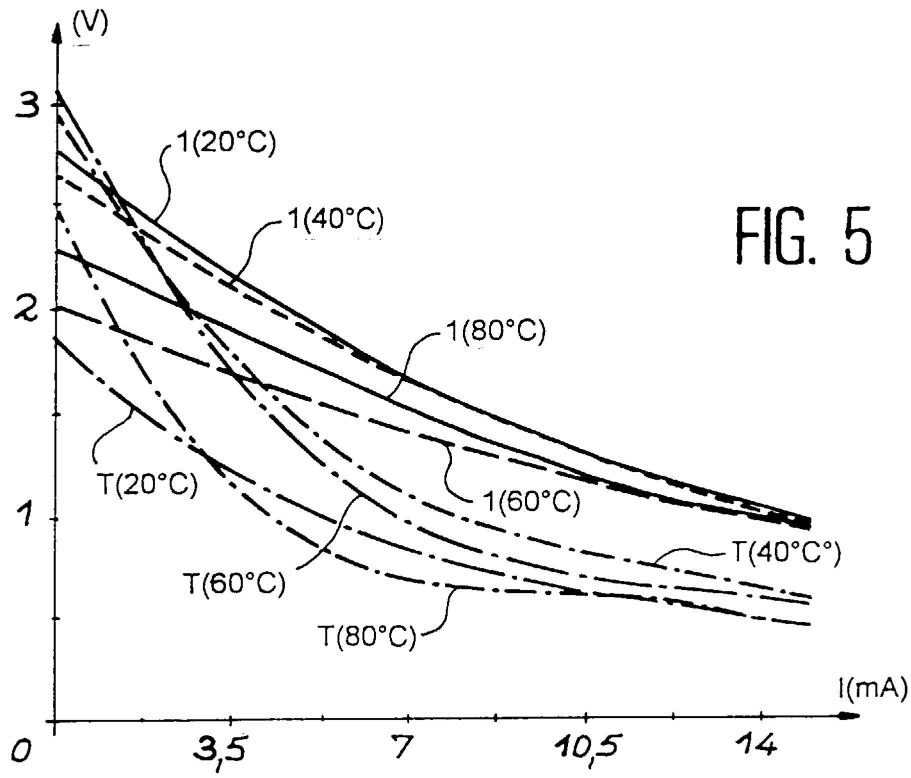
(V)
3
2
1
0
3,5
7
10,5
14
I(mA)
1(20°C)
1(40°C)
1(80°C)
1(60°C)
T(20°C)
T(40°C°)
T(60°C)
T(80°C)

FIG. 5

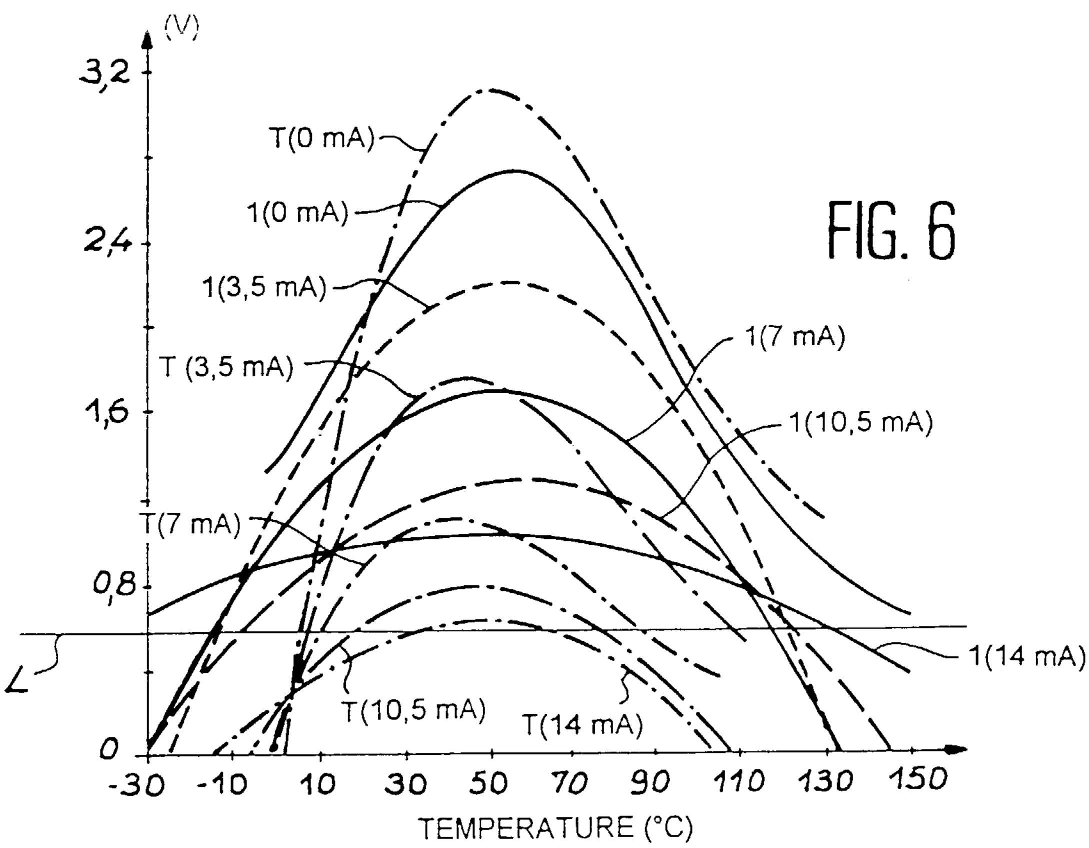
(V)
3,2
2,4
1,6
0,8
0
-30
-10
10
30
50
70
90
110
130
150
TEMPERATURE (°C)
T(0 mA)
1(0 mA)
1(3,5 mA)
T (3,5 mA)
1(7 mA)
1(10,5 mA)
T(7 mA)
L
1(14 mA)
T(10,5 mA)
T(14 mA)

FIG. 6

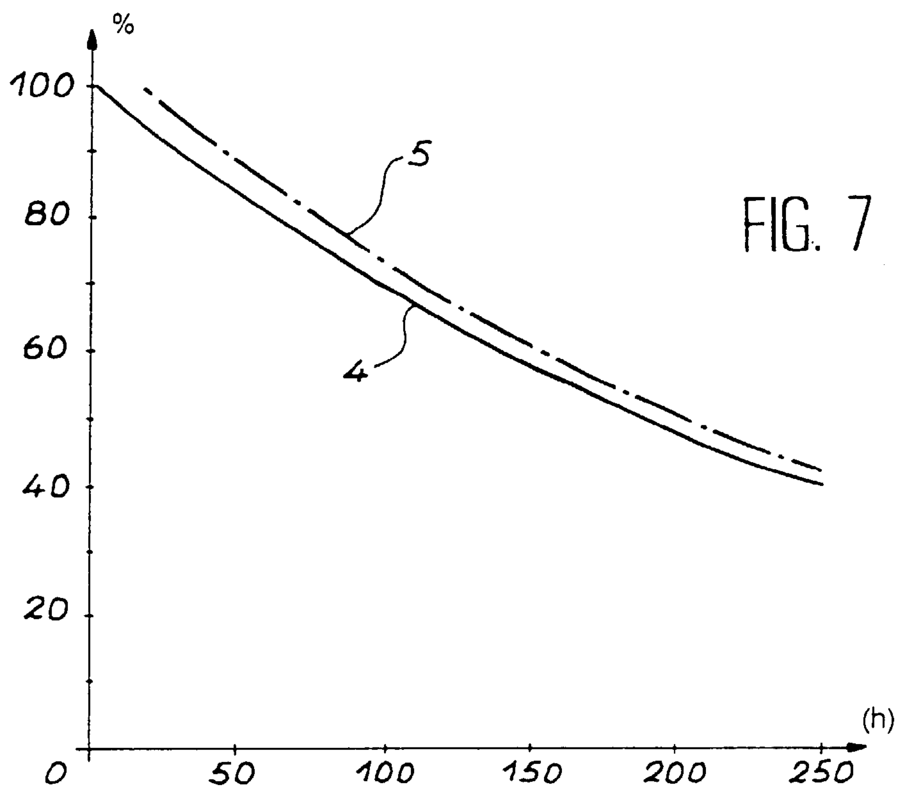
%
100
80
60
40
20
0
50
100
150
200
250
(h)
5
4

FIG. 7

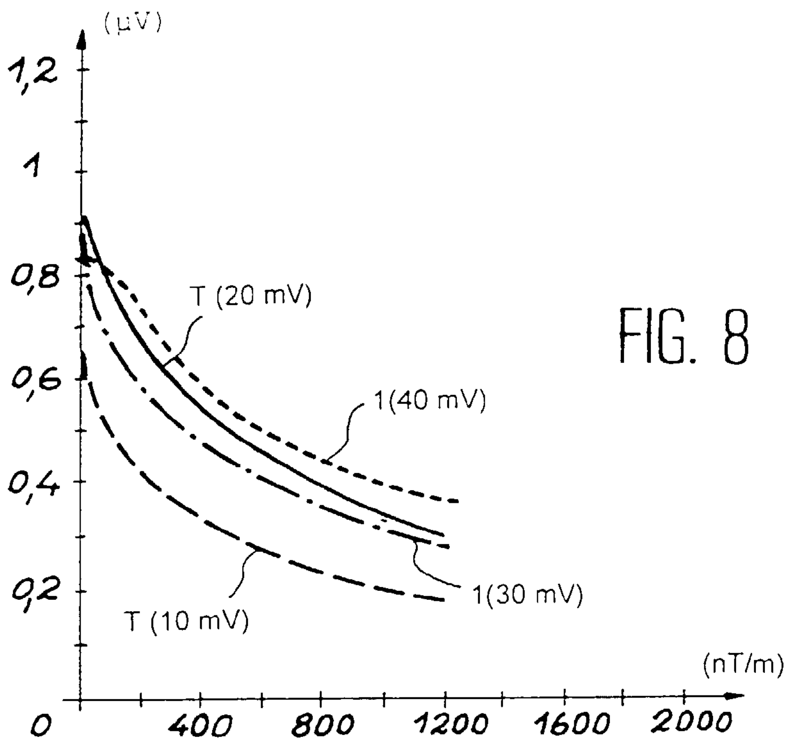
(µV)
1,2
1
0,8
0,6
0,4
0,2
0
400
800
1200
1600
2000
(nT/m)
T (20 mV)
1(40 mV)
1(30 mV)
T (10 mV)

FIG. 8

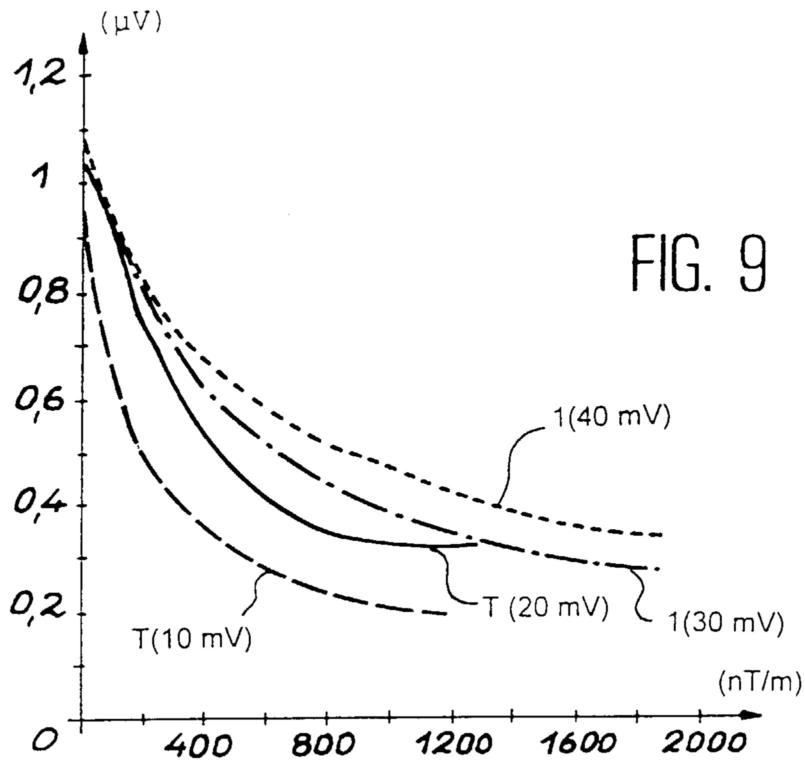
(µV)
1,2
1
0,8
0,6
0,4
0,2
0
400
800
1200
1600
2000
(nT/m)
1(40 mV)
T(10 mV)
T (20 mV)
1(30 mV)

FIG. 9

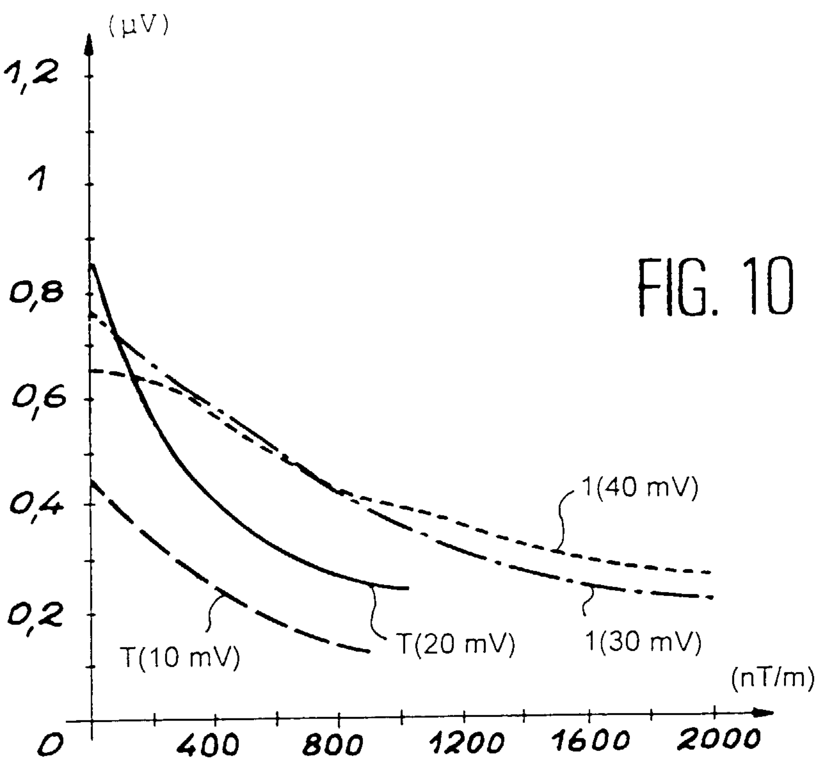
(µV)
1,2
1
0,8
0,6
0,4
0,2
0
400
800
1200
1600
2000
(nT/m)
1(40 mV)
T(10 mV)
T(20 mV)
1(30 mV)

FIG. 10

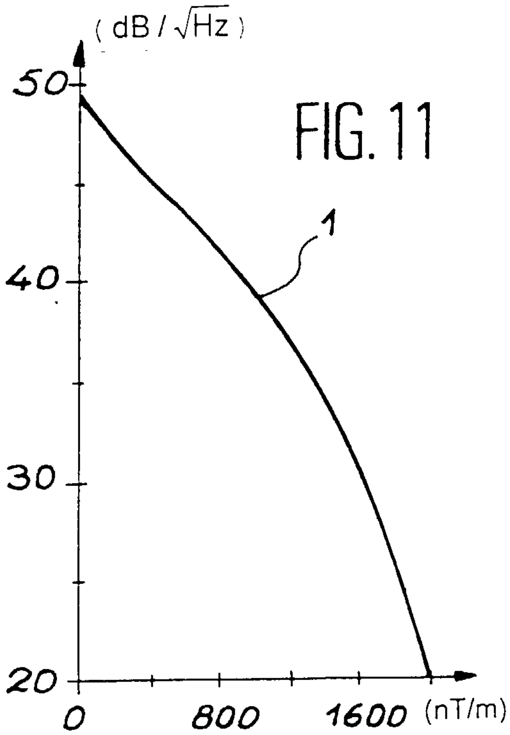


FIG. 11

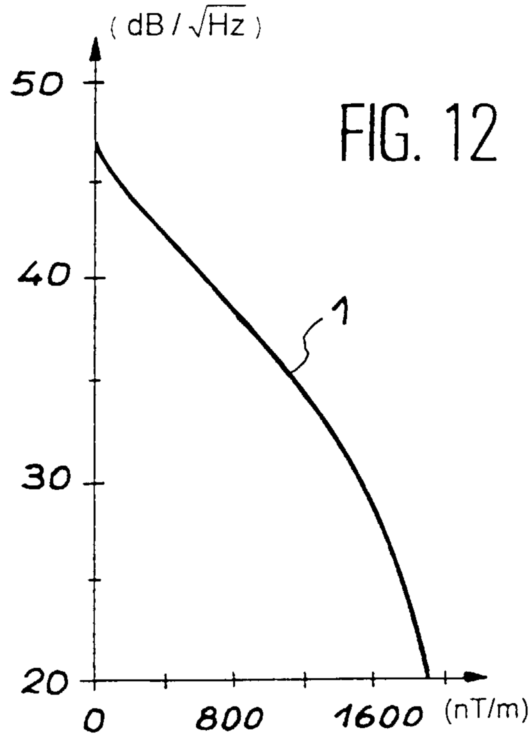


FIG. 12

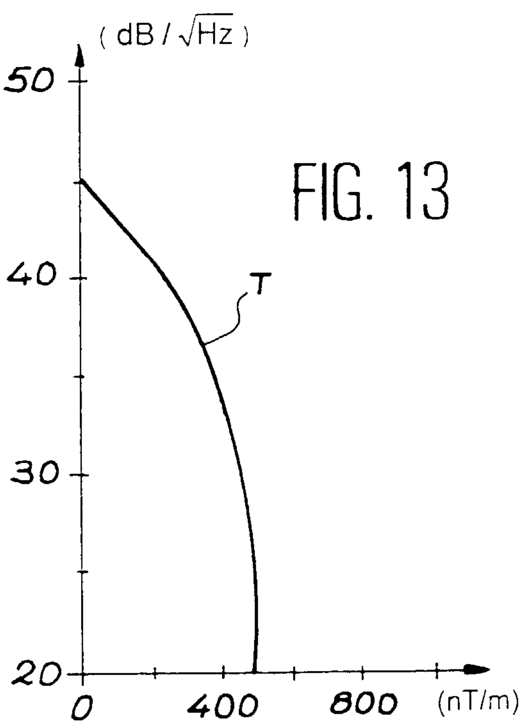


FIG. 13

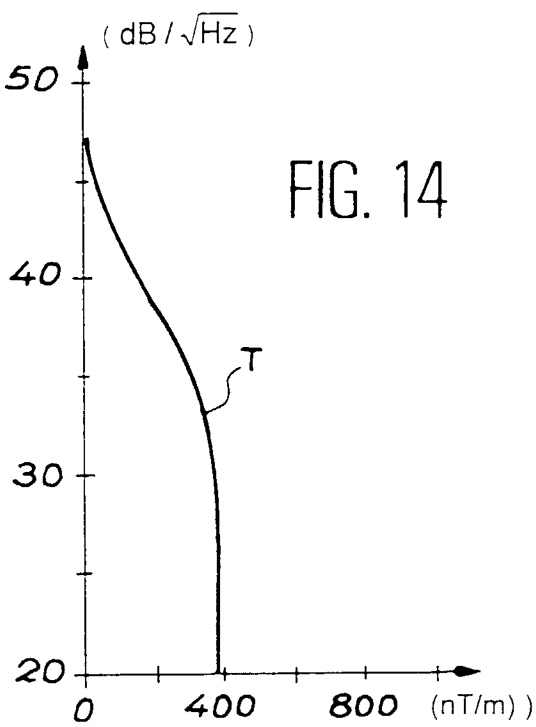


FIG. 14

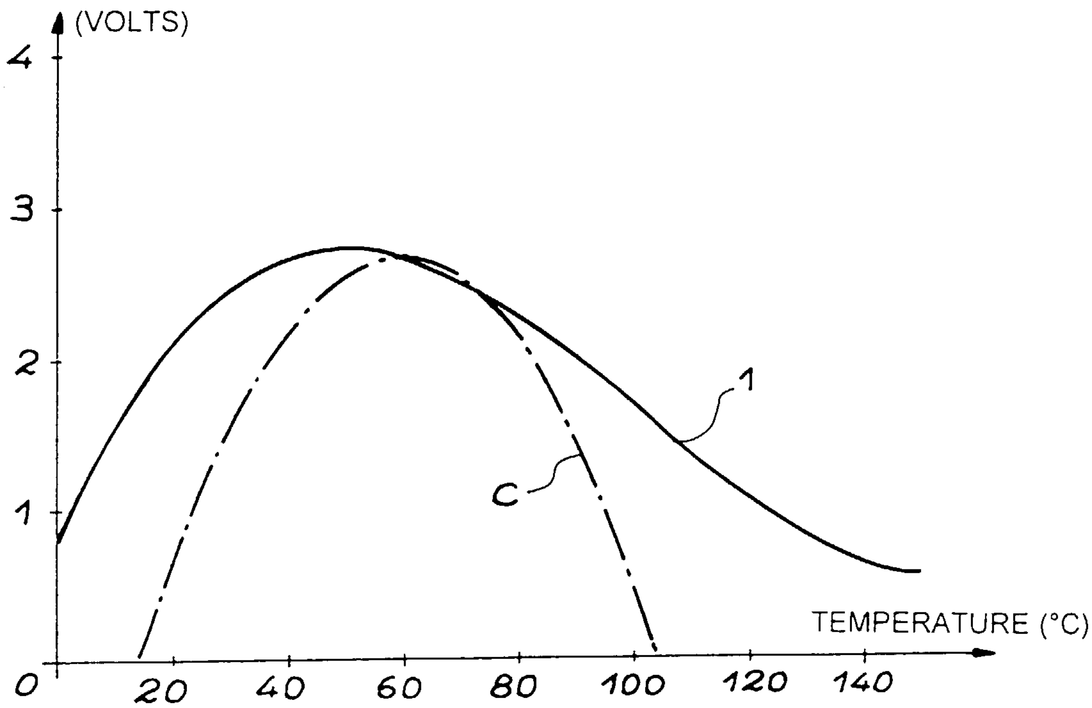


FIG. 15

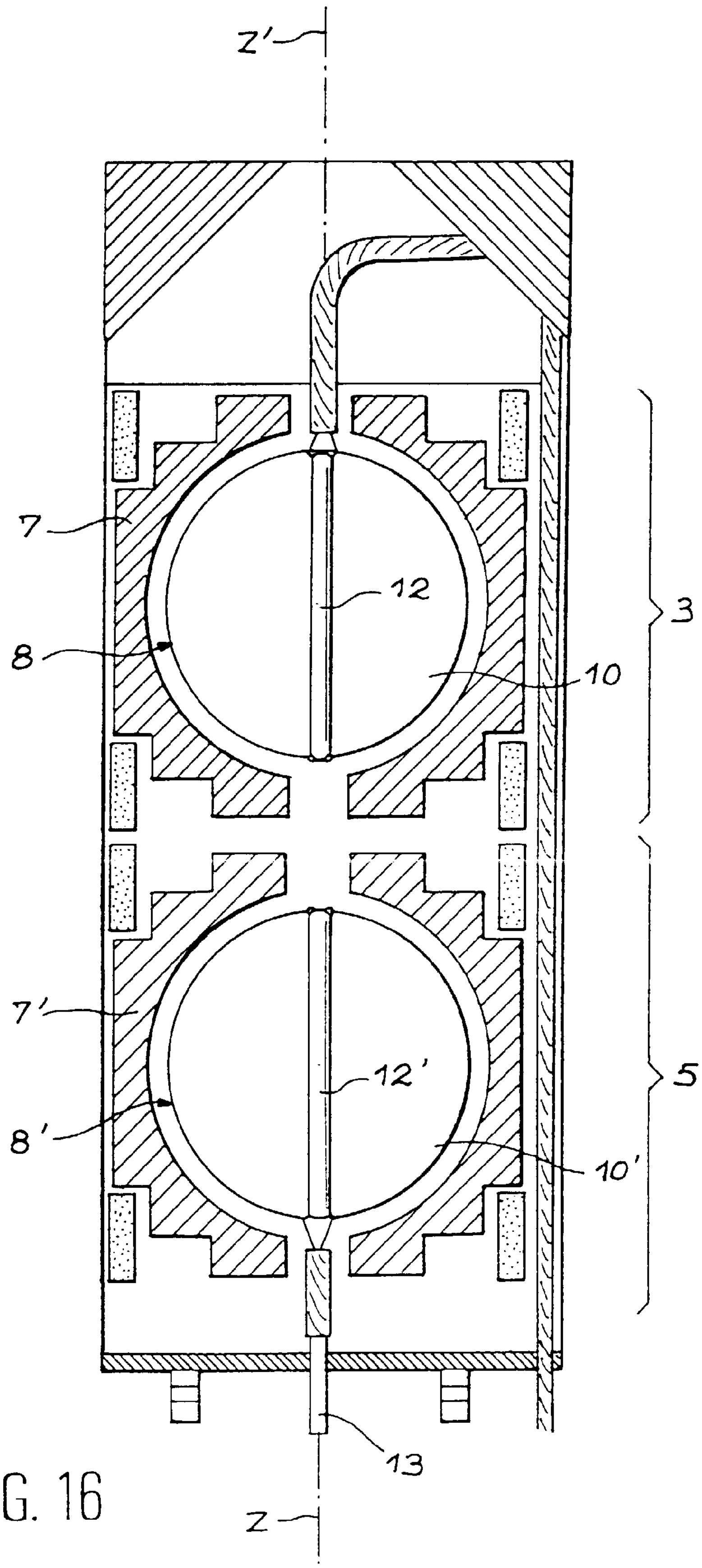


FIG. 16

Office européen des brevets

# RAPPORT DE RECHERCHE EUROPEENNE

Numero de la demande
EP 96 40 2759

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| A | WO 93 02710 A (NYCOMED INNOVATION AB)<br>* page 4, alinéa 4 - page 6, alinéa 2 *<br>* page 8, alinéa 4 *<br>* page 11, alinéa 2 *<br>* page 20, alinéa 1 - page 30, alinéa 3 *<br>* page 35, alinéa 4 *<br>--- | 1-3,6,7 | G01R33/24 |
| A | US 3 966 409 A (I. HRVOIC, K. HUMSKI)<br>* colonne 2, ligne 31 - ligne 42 *<br>* colonne 3, ligne 41 - colonne 4, ligne 19 *<br>--- | 1-8 | |
| D,A | JOURNAL OF THE CHEMICAL SOCIETY, PERKIN TRANSACTIONS 2,<br>1993,<br>pages 2049-2052, XP000566458<br>R. BOLTON ET AL.: "An EPR and NMR study of some Tetramethylisoindolin-2-yloxyl Free Radicals"<br>* page 2049, introduction *<br>* pages 2050 - 2052, "Results" *<br>--- | 1-3,6,7 | DOMAINES TECHNIQUES RECHERCHES (Int.Cl.6) |
| A | EP 0 423 033 A (COMMISSARIAT A L'ENERGIE ATOMIQUE)<br>* page 5, ligne 24 - page 6, ligne 19 *<br>* page 8, ligne 55 - page 10, ligne 36 * | 1-8 | G01R<br>C07B |
| D | & FR 2 653 121 A<br>----- | | |

Le présent rapport a été établi pour toutes les revendications

| Lieu de la recherche | Date d'achèvement de la recherche | Examinateur |
|---|---|---|
| LA HAYE | 19 Mars 1997 | Volmer, W |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)